# EUROPÄISCHE PATENTSCHRIFT

(11) **EP 2 320 215 B1**
(45) Veröffentlichungstag und Bekanntmachung des Hinweises auf die Patenterteilung: **01.05.2013**
(21) Anmeldenummer: 09013934.6
(22) Anmeldetag: 06.11.2009
(51) Int. Cl.: G01N 21/35, G01N 21/39, G01J 3/10, G01J 3/42, H01S 5/183

(54) **Halbleiterlaser-Aufbau zur Gasdetektion mit integriertem temperiertem Strahlformungselement**
Semiconductor laser system for gas detection with integrated and thermally controlled beam shaping element
Système laser à semi-conducteur de détection de gaz avec élément de mise en forme de faisceau intégré et commandé thermiquement

(43) Veröffentlichungstag der Anmeldung: 11.05.2011
(73) Patentinhaber: Axetris AG, 6056 Kägiswil (CH)
(72) Erfinder: Willing, Bert, 1807 Blonay (CH); Protasio, Rui, 6005 Luzern (CH); Gaillard, Mathieu, 1004 Lausanne (CH)
(74) Vertreter: Klocke, Peter

(56) Entgegenhaltungen:
- EP-A1- 1 783 481
- EP-A2- 1 207 599
- WO-A1-97/40558
- DE-A1- 10 108 873
- US-A1- 2003 007 257
- US-A1- 2005 083 568
- US-A1- 2005 141 829
- US-A1- 2006 274 807

## Beschreibung

Die Erfindung betrifft einen Halbleiterlaser-Aufbau zur Gasdetektion, der in einem hermetisch abdichtenden Gehäuse mit einem Fenster aufgenommen ist, wobei in dem Gehäuse Einrichtungen zur Reduzierung oder Vermeidung von Interferenzerscheinungen des Laserstrahls vor oder beim Austritt aus dem geschlossenen hermetisch abgedichteten Gehäuse angeordnet sind.

Für eine Vielzahl von Aufgaben im Bereich Sicherheit, Komfort und Umweltschutz besteht ein großer Bedarf an kostengünstigen, zuverlässigen und hoch empfindlichen Gassensoren. Bei bekannten Gassensoren erfolgt der Nachweis von Gasen häufig durch Anwendung der Absorptionsspektroskopie. Im Rahmen dieser Technik wird ein Lichtstrahl, beispielsweise ein Laserstrahl einer ausgewählten Frequenz, die von dem jeweiligen Gas, für die der Gassensor ausgelegt ist, stark absorbiert wird, durch ein Gas oder ein Gasgemisch geleitet. Der Absorptionsgrad des Lichtstrahls wird dabei als Indikator für den Konzentrationswert des zu detektierenden Gases benutzt. Für die Gasdetektion eignen sich insbesondere spektral einmodige Laserdioden, die mittlerweile auch für Betriebstemperaturen bis zu 100 °C hergestellt werden können.

Zum Stand der Technik wird auf die Druckschriften DE 197 17 145 C2 sowie DE 101 08 873 A1, EP 1 783 481 A1, EP 1 207 599 A2, US 2005/0 083 568 A1, WO 97/40 558 A1 und US 2006/274 807 A1 verwiesen.

Mit der deutschen Patentschrift DE 197 17 145 C2 ist als Stand der Technik ein Verfahren bekannt geworden, das mit einer monomodigen DFB-Laserdiode, unter Ausnutzung der Abstimmbarkeit dieser Diode bezüglich der Emissionswellenlänge über die Arbeitstemperatur der Diode, Teile der Spektren von zu messenden Gasen aufnimmt bzw. abscannt und dabei die Gase anhand ihrer charakteristischen Spektrallinien detektiert und anschließend die Konzentration des Gases bestimmt. In der allgemeinen Ausführung der Messmethode wird üblicherweise die Laser-Betriebstemperatur mittels eines thermoelektrischen Kühlers (Peltier-Element) konstant gehalten und die Abstimmung der Wellenlänge mittels Variation des Betriebsstromes der Laserdiode herbeigeführt. Insbesondere bei der abstimmbaren Laser-Gas-Detektion (TDLS) ist es für eine hohe Nachweisempfindlichkeit erforderlich, dass die von dem Laserdiodenhalbleiterchip emittierte Laserstrahlung mit möglichst geringen Interferenzerscheinungen aus der Laserdiode austritt. Solche Interferenzen können durch Reflexionen des Laserlichts an spiegelnden Innenflächen des Gehäuses der Laserdiode bzw. an der Innen- oder Außenfläche des Fensters der Laserdiode ausgehen oder von entsprechenden Flächen der in dem Gehäuse angeordneten Komponenten.

Die Schrift DE 101 08 873 A1 lehrt ein optoelektronisches Modul mit mindestens einem optoelektronischen Bauteil und mindestens einer Kopplungsvorrichtung zur Kopplung des Bauteils an jeweils einen Lichtwellenleiter. Die Kopplungsvorrichtung ist entlang der optischen Achse des optoelektronischen Bauteils angeordnet und umfasst eine einzige Linse zur Abbildung eines Koppelbereiches des Lichtwellenleiters auf einen jeweils zugeordneten Koppelbereich des optoelektronischen Bauteils. Das optoelektronische Bauteil weist einen Halbleiterlaser mit einem Laserdiodenaufbau auf, bei dem ein Laserdiodenchip auf einem ebenen Substratträger angeordnet ist. Der Substratträger ist wiederum auf einem L-förmigen Träger angeordnet, der von einem Peltier-Element getragen ist. Das optoelektronische Modul weist einen Boden auf, auf dem der Halbleiterlaser angeordnet ist und ein gegenüber der Laserapertur des Laserchips geneigtes Austrittsfenster für den erzeugten Laserstrahl. Der L-förmige Träger für den Laserdiodenchip ist mit einem ersten ungeteilten Schenkel mit dem Peltier-Element verbunden und weist einen zweiten geteilten, senkrecht zu der optischen Achse des Laserstrahls orientierten Schenkel auf, bei dem in einem mittigen Bereich eine Ausnehmung zur Bildung von zwei Teilschenkeln vorgesehen ist. Zur Kollimierung des Laserstrahls ist zwischen der Laserapertur des Laserdiodenchips und dem Austrittsfenster beispielsweise eine Kugellinse angeordnet. Die Linse ist an den Teilschenkeln des Trägers in Strahlerstreckungsrichtung mit Abstand zu der Laserapertur befestigt.

Die Europäische Offenlegungsschrift EP 1 783 481 A1 behandelt einen Lichtsender für einen Gasdetektor. Der Lichtsender umfasst einen abstimmbaren Halbleiterlaser mit einem üblichen Laserdiodenaufbau, der in einem geschlossenen Gehäuse angeordnet ist. Dabei ist ein Laserdiodenchip auf einem Substratträger befestigt und einem geneigten Austrittsfenster mit Abstand gegenüberliegend angeordnet. Zur Formung des Laserstrahls wird eine in dem Gehäuse des Lichtsenders angeordnete, dem Laserdiodenaufbau zugeordnete, mit einer Gehäusewand verbundene Kollimatorlinse verwendet, die entfernt von dem Austrittsfenster und dem Laserdiodenchip angeordnet ist.

Die EP 207 599 A2 beschreibt einen oberflächenemittierenden Laser, mit vertikalem Resonator und eingebauter kollimierender Mikrolinse. Die Mikrolinse ist insbesondere durch Waverbonden mit dem VCSEL-Laserdiodenchip verbunden. Dabei fällt ein Fokuspunkt der Mikrolinse mit dem Laserlicht produzierenden Bereich des aktiven Layers des Laserdiodenchips zusammen. Die Verbindung ist adhäsiv und/oder stoffschlüssig.

Die WO 97/40 588 A1 offenbart einen optisch fokussierenden rückseitig emittierenden VCL-Laser, mit einem vorderen und einem hinteren teildurchlässigen Resonatorspiegel, die einander gegenüberliegend angeordnet sind und mit einem dazwischen liegenden optischen Resonator, der eine zentrale vertikale Achse und einen aktiven Bereich zwischen den Resonatorspiegeln aufweist. Am hinteren Resonatorspiegel ist eine kollimierende Mikrolinse angeordnet, die stoffschlüssig oder adhäsiv mit der Laserapertur verbunden ist, wobei die Achse der Mikrolinse sich mit der zentralen Achse des Resonators decken oder gegenüber dieser seitlich verschoben sein kann.

Die US 2006/027 807 A1 befasst sich mit einem oberflächenemittierenden pumpbaren Laser mit einem vertikalen Resonator mit darin integriertem Laserdiodenchip und mit zwei gekrümmten Resonatorspiegeln, die in einem 90°-Winkel zueinander angeordnet sind. Der VCL-Laser weist einen eingefügten Pumplaser auf, der auf einer als Wärmesenke wirkenden Kühleinrichtung angeordnet ist, wobei an der Laserapertur des Pumplasers eine kollimierende Mikrolinse angeordnet ist, die mit dem Pumplaser verbunden ist.

Die US 2005/0 083 568 A1 schlägt ein Halbleiterlasermodul mit einem Gehäuse vor, das ein geneigtes Austrittsfenster aufweist, wobei in dem Gehäuse ein Peltier-Element angeordnet ist, das einen zweiteiligen Träger für den Laserdiodenchip und eine Kollimatorlinse zur Formung des Laserstrahls aufweist. Ein erstes Trägerteil mit den Flächenabmessungen des Peltier-Elements trägt den Substratträger mit dem Laserdiodenchip direkt und in einer Ausnehmung das zweite Trägerteil, auf dem die Kollimatorlinse angeordnet ist. Die Kollmatorlinse und der Laserdiodenchip sind einander fern positioniert und weisen keinen direkten Kontakt zueinander auf. Bei der Laserabsorptionsspektroskopie wird die Absorption des von der Laserdiode ausgestrahlten Lichtes nach dem Durchtritt durch einen ein Gas oder ein Gasgemisch aufweisenden Messbereich mittels einem Detektor, beispielsweise einem lichtempfindlichen Halbleiterelement oder einem thermischen Sensorelement erfasst und das empfangene Signal einem Signalanalysator zugeleitet. Der Signalanalysator kann konstante Interferenzmuster problemlos bei der Auswertung von dem empfangenen Signal abtrennen. Sich ändernde Interferenzmuster können im Gegensatz dazu bei der Auswertung des empfangenen Signals nicht vollständig eliminiert werden, so dass das Rauschen des Laserstrahlempfängers deutlich erhöht wird, womit die Nachweisempfindlichkeit für die zu detektierenden Gase sinkt. Sich ändernde Interferenzmuster werden meist durch nicht eliminierbare Temperatureinflüsse an oder in dem Gehäuse des Laserdioden-Aufbaus verursacht, die eine Veränderung der Länge des optischen Pfades des Laserlichtes in dem Gehäuse des Laserdioden-Aufbaus nach sich ziehen. Für den Fall, dass bei dem Laserdioden-Aufbau zwischen dem an dem Gehäuseboden befestigten Laserdiodenchips und dem Gehäusefenster beispielsweise eine Mikrolinse als Kollimator für den Laserstrahl angeordnet ist, treten Reflexionen des an einer Laserapertur des Laserdiodenchips austretenden Laserlichtes natürlich auch an quer zu dem Laserstrahl verlaufenden Grenzflächen der Mikrolinse auf. Diese Reflexionen können wie die entsprechenden Reflexionen des Laserstrahls an dem Gehäusefenster ebenfalls zu Interferenzmustern führen, die sich mit etwaigen anderen vorkommenden Interferenzmustern überlagern. Die durch die Mikrolinse verursachten Interferenzmuster können sich ebenfalls Temperatur abhängig verändern und wirken sich damit negativ auf die Auflösung des Gassensors aus.

Der Erfindung liegt die Aufgabe zu Grunde, eine Möglichkeit vorzuschlagen, mit der die Sensitivität eines Gassensors verbessert wird, indem Interferenzerscheinungen des Laserstrahls vor und bei dem Austritt aus dem vorzugsweise geschlossenen hermetisch abgedichteten Gehäuse eines Halbleiterlaser-Aufbaus zur Gasdetektion vermieden oder deutlich reduziert werden.

Diese Aufgabe wird erfindungsgemäß durch einen Halbleiterlaser-Aufbau mit den Merkmalen des Anspruchs 1 zur Reduzierung von Interferenzerscheinungen gelöst. Weitere vorteilhafte Ausgestaltungen sind den rückbezogenen Ansprüchen zu entnehmen.

Danach weist der Halbleiterlaser-Aufbau zur Gasdetektion einen Halbleiterlaserchip auf, der in einem hermetisch abgedichteten Gehäuse mit einem Boden und einem Fenster angeordnet ist. Der Halbleiterlaserchip ist dabei von einer geregelten Temperatureinrichtung getragen, die in dem Gehäuse aufgenommen ist. Zwischen dem Fenster und dem Halbleiterlaserchip ist ein optisches, für Laserlicht durchgängiges Strahlformungselement positioniert, das einen von der Laserapertur des Halbleiterlaserchips ausgehenden Laserstrahl vor dem Durchtritt durch das Fenster kollimiert, wobei das Fenster gegenüber der Mittelachse des Laserstrahls geneigt angeordnet ist, so dass an dem Fenster austretende Rückreflexionen des Laserstrahls die Laserapertur verfehlen. Das Strahlformungselement ist adhäsiv und/oder stoffschlüssig optisch und mechanisch mit dem Halbleiterlaserchip verbunden und weist damit gegenüber diesem einen konstanten Temperaturzustand auf.

Prinzipiell wird bei der Erfindung unter Linse ein optisch wirksames Bauelement mit einander gegenüberliegenden lichtbrechenden Flächen verstanden, das kollimierend wirkt, und einen parallelen Strahlenverlauf des aus dem Halbleiterlaserchips austretenden Laserlichtes erzeugt. Als Linsenmaterial für die Mikrolinse sind für das Laserlicht transparente Stoffe wie Glas, Kristalle oder einige spezielle Kunststoffe geeignet. Der Brechungsindex der Linse kann dabei in und/oder quer zu der Achse der Linse konstant ausgebildet sein oder stetig variieren. In jedem Fall handelt es sich dabei um eine Linse, die den Strahl einer im Fokus liegenden Lichtquelle, insbesondere einer Laserlichtquelle, parallelisieren kann. Erfindungsgemäß wird als Strahlformungselement für den erfindungsgemäßen Halbleiterlaser-Aufbau eine kugelförmig ausgebildete Mikrolinse oder eine zylindrische GRIN-Linse verwendet.

Erfindungsgemäß weist die GRIN-Linse eine parallel zu der Laserapertur verlaufende dieser zugewandte Grenzfläche auf. Bei der vorstehend spezifizierten Mikrolinse bewegt sich das Laserlicht durch die homogene Brechzahl des Linsenmaterials geradlinig in der Linse, während es sich bei der GRIN-Linse (Gradienten-Index-Linse) auf Grund der inhomogenen Brechzahl in der Linse entlang einer gekrümmten Bahn bewegt. Meist nimmt bei einer GRIN-Linse die Brechzahl quadratisch mit dem Abstand zur Mittelachse ab (Parabelfunktion). Ein Stab aus einem solchen Material wirkt wie eine gewöhnliche Sammellinse, er besitzt aber in der Regel an den Lichteintritts- und den Lichtaustrittsseiten plane Oberflächen. Dadurch werden die Montage, die Miniaturisierung und die Verbindung mit nachfolgenden optischen Elementen vereinfacht.

Bei dem erfindungsgemäßen Halbleiterlaser-Aufbau ist das Gehäuse hermetisch abgedichtet. Dabei ist das Fenster des Gehäuses, das die Austrittsöffnung verschließt, gegenüber der Mittelachse des Laserstrahls derart geneigt angeordnet, dass an dem Fenster auftretende Reflexionen des Laserstrahls in Richtung des Halbleiterlaserchips die Laserapertur des Halbleiterlaserchips verfehlen. Ein Azimutwinkel der Fensterneigung hat einen festen Bezug zu einem Polarisationsvektor des Laserstrahls, indem der Polarisationsvektor in der Einfallsebene des Fensters liegt. Dabei kann das Fenster dem Boden mit dem Halbleiterlaserchip gegenüberliegend parallel oder geneigt oder an von dem Boden sich weg erstreckenden Seitenwänden des Gehäuses entsprechend angeordnet sein. Der Laserstrahl, der auf die dem optischen Strahlformungselement zugewandte Innenseite des Fensters trifft, verhält sich bezüglich Transmission und Reflexion entsprechend dem aus der Optik bekannten Brewster-Winkel.

Außerdem ist bei dem erfindungsgemäßen Halbleiterlaser-Aufbau gemäß Anspruch 1 das Strahlformungselement in physischem Kontakt mit dem Halbleiterlaserchip, der den konstanten Temperaturzustand zwischen dem Halbleiterlaserchip und dem Strahlformungselement sicherstellt. Dabei ist das Strahlformungselement abstandslos mit dem Halbleiterlaserchip verbunden.

Indem das Strahlformungselement über eine Schicht aus Klebstoff in physischem Kontakt mit dem Halbleiterlaserchip ist, weist es eine von dem Halbleiterlaserchip bestimmte Temperatur auf. Der Kontakt zu dem Halbleiterlaserchip ermöglicht einen Wärmeübergang zwischen dem Halbleiterlaserchip und dem Strahlformungselement, der die Temperatur des Strahlformungselementes an die Temperatur des Halbleiterlaserchips heranführt. Nach kurzer Betriebszeit ändert sich die Temperaturdifferenz zwischen dem Halbleiterlaserchip und dem Strahlformungselement nicht mehr, wobei das Strahlformungselement und der Halbleiterlaserchip im Idealfall die gleiche Temperatur aufweisen.

Dabei sind der Halbleiterlaserchip und Strahlformungselementgetrennt voneinander, vorzugsweise einstückig, hergestellt und nachträglich derart miteinander verbunden, dass der innige physische Kontakt zwischen dem Halbleiterlaserchip und dem Strahlformungselement erreicht wird.

Das optische Strahlformungselement in Form einer Linse ist bei der Erfindung direkt über eine Schicht aus Klebstoff auf dem Halbleiterlaserchip angeordnet und mit einer Grenzfläche mit der Laserapertur des Halbleiterlaserchips verbunden. Es kann aus einem nicht verformbaren festen Material, beispielsweise Glas oder einem nachgiebigen festen Material, beispielsweise Kunststoff geformt sein, das einen geeigneten Brechungsindex aufweist. Bei einer Linse aus einem solchen Material ist die Verbindung vorzugsweise stoffschlüssig bzw. adhäsiv. Dabei ist das Strahlformungselement so justiert, dass die Laserapertur vorzugsweise in der Fokalebene des Strahlformungselements liegt. Als stoffschlüssige Verbindungen werden alle Arten von nicht lösbaren Verbindungen angesehen, bei denen die Verbindungspartner durch atomare oder molekulare Kräfte zusammengehalten werden und die sich nur durch Zerstörung der Verbindungsmittel trennen lassen.

Erfindungsgemäß ist der Halbleiterlaserchip, an dem das Strahlformungselement befestigt ist, auf einer geregelten Temperiereinrichtung angeordnet. Die Temperiereinrichtung kann beispielsweise von einem an sich bekannten Peltier-Element gebildet sein. Mittels der Temperiereinrichtung mit entsprechender Temperaturregelung befinden sich Strahlformungselement und Halbleiterlaserchip immer auf der gleichen Temperatur. Dies kann mittels dem Peltierelement, einer reinen Heizung oder einer Kombination aus Heizung und Peltierelement erfolgen. Damit weisen insbesondere die Laserapertur des Halbleiterlaserchips und die dieser zugeordnete Grenzfläche des Strahlformungselementes eine einheitliche Temperatur auf. Durch die gleiche Temperatur des Halbleiterlaserchips und der Linse treten bei der stoffschlüssigen Verbindung keine nicht beherrschbaren mechanischen Spannungen auf, die die Zuverlässigkeit des Gasdetektor-Halbleiterlaser-Aufbaus mindern könnten. Durch die abstandslose Verbindung von Laserapertur und Strahlformungselement ist die Gefahr einer Reflexion eines Teils des Laserlichtes des Laserstrahls an der der Laserapertur zugewandten Grenzfläche dem Strahlformungselement deutlich reduziert.

Erfindungsgemäß ist das Strahlformungselement, d.h. die Linse, als gesondertes Teil hergestellt und mit einem Klebstoff an der Laserapertur befestigt. Der Klebstoff ist Vorzugsweise als homogene Schicht zwischen der Laserapertur und der Linse angeordnet. Beim Übertritt von der Laserapertur zu der Klebstoff schicht und von der Klebstoff schicht zu der Grenzfläche der Linse werden die Lichtwellen des Laserstrahls jeweils gemäß dem Snell-Gesetz gebrochen. Das Snell-Gesetz besagt, dass die Lichtwellen ihre Richtung ändern, wenn sie von einem transparenten Medium mit einer bestimmten Phasengeschwindigkeit in ein anderes transparentes Medium mit einer anderen Phasengeschwindigkeit übergehen. Es gibt an, in welcher Richtung die Welle abgelenkt wird. Dabei bewegt sich das Laserlicht in dem jeweiligen Medium mit einer von der Brechzahl des Mediums abhängigen Ausbreitungsgeschwindigkeit. Die Brechzahl gibt das Verhältnis der Phasengeschwindigkeit von Licht im Vakuum zur Phasengeschwindigkeit des Lichtes in dem Medium an. Bekanntermaßen liegt die Brechzahl einer Klebstoffschicht, der Brechzahl einer Linse wesentlich näher als die Brechzahl eines optisch dünneren Gases, so dass das Laserlicht beim Übergang von dem Halbleiterlaserchip zu dem aufgesetzten und verklebten Strahlformungselement weit weniger gebrochen wird als ohne zwischen der Laserapertur und der zugeordneten Grenzfläche des Strahlformungselementes angeordneter Klebstoffschicht. Der Klebstoff weist vorzugsweise einen dem Strahlformungselement ähnlichen oder gleichen Brechungsindex auf.

Um Streulicht in dem Gehäuse des Halbleiterlaser-Aufbaus durch Beugung des Laserstrahls beim Übergang von dem Halbleiterlaserchip zu dem Strahlformungselement vorzubeugen, das parallel zum dem aus dem Halbleiterlaserchip austretenden Laserstrahl in Richtung der Laserapertur rückreflektiert werden kann, sind Strahlformungselement und Laserapertur des Halbleiterlaserchips vorteilhafterweise einheitlich in Form und/oder Größe ausgebildet. Damit entspricht der Öffnungswinkel des aus der Laserapertur austretenden Laserstrahls einer Apertur des Strahlformungselements. Es versteht sich von selbst, dass das Strahlformungselement auch größer als die Laserapertur der Halbleiterlaserchips ausgebildet sein kein und dass die Form der Grenzfläche dabei auch von der Form der Laserapertur abweichen kann, solange diese die Laserapertur vollständig überdeckt.

Es hat sich als besonders günstig erwiesen, einen Klebstoff zum Verbinden des Strahlformungselements mit der Laserapertur zu wählen, das einen Brechungsindex aufweist, der dem des Strahlformungselements entspricht. Durch den einheitlichen Brechungsindex der Klebstoff schicht und des Strahlformungselements wird das Verbundsystem Halbleiterlaserchip, Klebstoff schicht und Strahlformungselement auf eine einzige lichtbrechende Grenzfläche zwischen diesen reduziert. Die wirksame Grenzfläche ist zwischen der Laserapertur und der Haftmittelschicht angeordnet. Die dem Halbleiterlaserchip und der Klebstoff schicht zugewandte Grenzfläche des Strahlformungselements wird unterdrückt, so dass der Laserstrahl vom Austritt aus dem Halbleiterlaserchip bis zum Austritt aus dem Strahlformungselement nur ein einziges Mal an dem Übergang zwischen der Laserapertur und dem Klebstoff gebrochen wird. Damit entfällt auch eine mögliche Reflexionsfläche für das Laserlicht in dem Gehäuse des Halbleiterlaser-Aufbaus.

Bei einer vorteilhaften Ausführungsform der Erfindung ist die optische Achse des Strahlformungselements gegenüber der Mittelachse der Laserapertur versetzt angeordnet. Die Linse wird dabei nicht genau zentriert über der Laserapertur positioniert, sondern einige 10 µm versetzt zu der Achse der Laserapertur. Dies bedingt natürlich, dass die von der Grenzfläche gebildete Apertur eines beispielsweise als Mikrolinse ausgeführten Strahlformungselements mindestens um den Betrag des Versatzes größer ausgebildet ist als die Laserapertur des Halbleiterlaserchips. Im Gegensatz dazu ist bei einem als GRIN-Linse ausgebildeten Strahlformungselements die Apparatur der Mikrolinse zweckmäßigerweise konzentrisch zu der Laserapertur angeordnet, wobei vorteilhafterweise die der Laserapertur abgewandte Grenzfläche abgeschrägt ausgeführt ist.

Damit unerwünschte Interferenzmuster des aus dem Fenster austretenden Laserstrahls weitgehend unterdrückt werden, verhält sich, wie vorstehend bereits erwähnt, der Laserstrahl, der auf die dem optischen Strahlformungselement zugewandte Innenseite des schrägen Fensters trifft, bezüglich Transmission und Reflexion entsprechend dem aus der Optik bekannten Brewster-Winkel. Dies kann gemäß einer weiteren Ausbildung durch eine Antireflexbeschichtung des Fensters des Gehäuses des Gasdetektor-Halbleiterlaser-Aufbaus in günstiger Weise zusätzlich unterstützt werden. Der Brewster-Winkel gibt denjenigen Winkel an, bei dem von dem einfallenden und polarisierten Licht nur die senkrecht zur Einfallsebene polarisierten Anteile reflektiert werden. Das Besondere bei der Einstrahlung im Brewster-Winkel ist, dass der unter einem bestimmten Winkel gebrochene Laserstrahl orthogonal auf dem reflektierten steht. Daher wird der gesamte parallel zu der Einfallsebene polarisierte Lichtstrahl gebrochen und nur der senkrecht zu der Einfallsebene polarisierte Anteil reflektiert.

Der vorgeschlagene Aufbau ist nicht auf VCSEL beschränkt, sondern kann sinngemäß für DFBs und beliebige andere Diodenlaser verwendet werden.

Bei der Verwendung des erfindungsgemäßen Halbleiterlaser-Aufbaus zur optischen Gasdetektion mittels einem Laserstrahl, der von dem Halbleiter-laserchip ausgesendet wird der in dem abgedichteten Gehäuse, das elektrische Anschlüsse, einen Boden und ein Fenster aufweist, auf einer geregelten Temperiereinrichtung angeordnet ist, wird durch ein zwischen dem Halbleiterlaserchip und dem Fenster vorgesehenes optisches Strahlformungselement in Form einer Linse, der von der Laserapertur des Halbleiterlaserchips ausgehende Laserstrahl vor dem Durchtritt durch das Fenster kollimiert. Dabei wird zur Reduzierung von Interferenzerscheinungen des Laserstrahls in dem Gehäuse, der von dem Strahiformungselement kollimierte Laserstrahl in einem Winkel derart auf das Fenster gerichtet, dass an dem Fenster auftretende Reflexionen des passierenden Laserstrahls an der Laserapertur des Halbleiterlaserchips vorbeigeführt werden. Dazu kann entweder das Fenster geneigt gegenüber einer Mittelachse des Laserstrahls angeordnet werden, die sich beispielsweise senkrecht zu der Laserapertur erstreckt oder der Laserstrahl bei parallel zu der Laserapertur angeordnetem Fenster durch geeignete Strahllenkungsmittel gegenüber dem Fenster geneigt werden. Das Strahlformungselement und der Halbleiterlaserchip werden insbesondere auf einen definierten Temperaturzustand gebracht, der konstant erhalten wird. Dabei können der Halbleiterlaserchip und das Strahlformungselement gleiche oder unterschiedliche Temperaturwerte aufweisen. Idealerweise entspricht die Temperatur des Strahlformungselements der des Halbleiterlaserchips. Das wird unter anderem dadurch erreicht, dass das Strahlformungselement mit dem Halbleiterlaserchip in gut wärmeleitendem Kontakt steht. Dazu wird das Strahlformungselement gemäß Anspruch 1 an dem Halbleiterlaserchip befestigt. Erfindungsgemäß wird das Strahlformungselement direkt über eine Schicht aus Klebstoff auf dem Halbleiterlaserchip angeordnet, wobei eine Grenzfläche des Strahlformungselements mit dem Halbleiterlaserchip mit der Laserapertur des Halbleiterlaserchips, ohne Zwischenraum verbunden wird. Für die Reduzierung von Etalons durch Selfmixing von zu der Laserapertur rückreflektierter Anteile des Laserstrahls wird eine konstante geringe, idealerweise keine Temperaturdifferenz zwischen dem Halbleiterlaserchip und dem Strahlformungselement benötigt.

Die Erfindung bringt den Vorteil, dass durch den nicht senkrecht auf das Fenster auffallenden kollimierten Laserstrahl mögliche an dem Fenster auftretende Rückreflexionen sich nicht dem auf das Fenster gerichteten Laserstrahl überlagern, so dass Interferenzerscheinungen des Laserstrahls innerhalb des Halbleiterlaser-Aufbaus sicher vermieden werden. Weiterer Vorteil ist, dass durch das temperierte Strahlformungselement, das mit dem Halbleiterlaserchip in einer wärmeleitenden Verbindung steht, keine wesentlichen Temperaturdifferenzen auftreten, so dass das Strahlformungselement keine negative Auswirkung auf die Etalons hat. Zudem wird durch die Reduzierung der Übertritte des Laserstrahls in dem Gehäuse von einem optisch dichteren zu einem optisch dünneren Medium oder umgekehrt die Anzahl an Grenzflächen auftretenden Spiegelungen verringert. Damit werden die Nachweisgrenzen bei einem Gassensor sowie dessen Zuverlässigkeit gegenüber bekannten Halbleiterlaser-Aufbauten deutlich erhöht. Dabei ist die Herstellung eines solchen Halbleiterlaser-Aufbaus kostengünstig, die Mehrkosten gegenüber herkömmlichen Halbleiterlaser-Aufbauten sind gering.

Nachfolgend wird die Erfindung anhand zweier in der Zeichnung dargestellter Ausführungsbeispiele näher erläutert. Weitere bevorzugte Merkmale der Erfindung ergeben sich aus der folgenden Beschreibung des bevorzugten Ausführungsbeispiels der Erfindung in Verbindung mit den Ansprüchen und der beigefügten Zeichnung. Es zeigen vereinfacht in schematischer Schnittdarstellung:
- Figur 1: einen Halbleiterlaser-Aufbau mit kugelförmiger Mikrolinse und einem geneigt zum Boden des Gehäuses verlaufenden Fenster; und
- Figur 2: einen Halbleiterlaser-Aufbau mit einer GRIN-Linse mit abgeschrägter Austrittsfläche und mit einem geneigt zum Boden angeordneten Fenster.

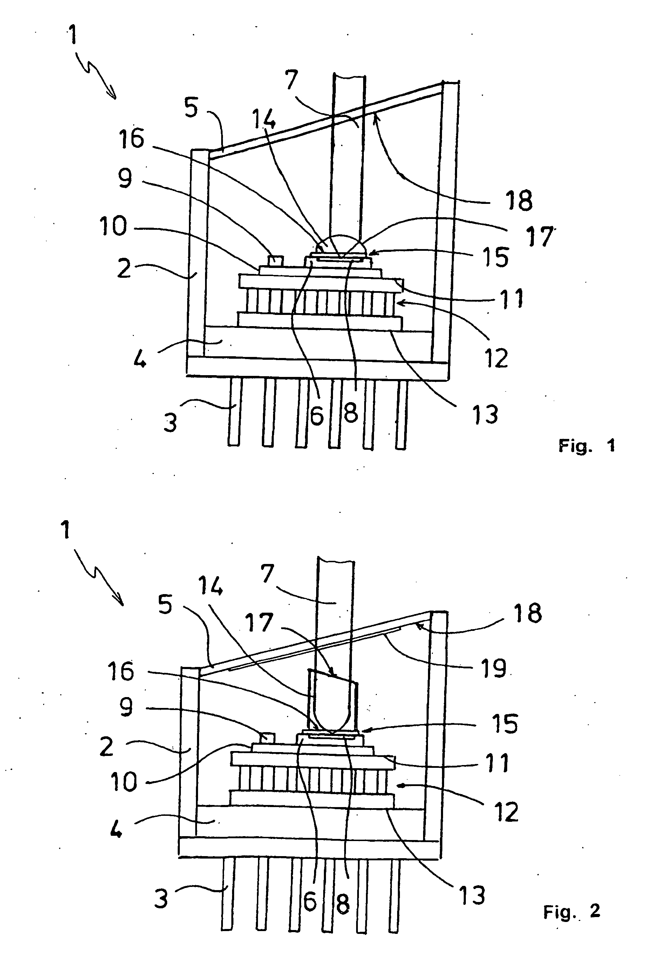

Figur 1 zeigt ein erstes bevorzugtes Ausführungsbeispiel eines Halbleiterlaser-Aufbaus 1 mit einem hermetisch abgedichteten Gehäuse 2, das eine Anzahl von elektrischen Anschlüssen 3 an einem Boden 4 des Gehäuses 2 aufweist. Dem Boden 4 gegenüberliegend ist ein Fenster 5 zum Austritt eines von einem Halbleiterlaserchip 6 emittierten Laserstrahls 7 aus dem Gehäuse 2 vorgesehen. Das Fenster 5 erstreckt sich schräg zu dem Boden 4 des Gehäuses 2 und zu einer Laserapertur 8 des Halbleiterlaserchips 6. Der Halbleiterlaserchip 6 ist zusammen mit einem Thermistor als Temperatursensor 9 auf einen Träger 10 aufgeklebt, der seinerseits mit einer kalten Flachseite 11 eines Peltier-Elements 12 verklebt ist. Das Peltier-Element 12 ist mit einer heißen Flachseite 13 mit dem Boden 4 des Gehäuses 2 verbunden, wobei der Thermistor 9 den Strom durch das Peltier-Element 12 regelt.

Zwischen dem Halbleiterlaserchip 6 und dem Fenster 5 der Laserdiode 1 ist eine Mikrolinse 14 die Laserapertur 8 übergreifend zur Kollimierung des Laserstrahls 7 angeordnet. Die Mikrolinse 14 ist von dem Halbleiterlaserchip 6 getragen und mit der Laserapertur 8 mittels einer Haftmittelschicht 15 aus Klebstoff stoffschlüssig verbunden. Die Mikrolinse 14 weist eine plane, der Laserapertur 8 zugewandte Grenzfläche 16 als Eintrittsapertur auf und eine zu dem Fenster 5 des Gehäuses 2 gerichtete, konvex gekrümmte Austrittsfläche 17. Die Eintrittsapertur 16 der Mikrolinse 14 und die Laserapertur 8 sind typisch quer zu dem Laserstrahl 7 um einige 10 µm versetzt. Dies bewirkt, dass mögliche parallel zu dem emittierten Laserstrahl 7 auftretende Reflexionen des Laserstrahls 7, beispielsweise von eine Grenzfläche bildenden Austrittsfläche 17 der Mikrolinse 14 die Laserapertur 8 verfehlen. Die Klebstoffschicht 15 weist eine geringe Stärke auf und einen Brechungsindex, der dem des Linsenmaterials der Mikrolinse 14 entspricht. Die Mikrolinse 14 ist als gesondertes Teil aus einem Polymer geformt und nach dem Aushärten des Polymers an dem Halbleiterlaserchip 6 mittels dem Klebstoff 15 montiert.

Figur 2 zeigt ein zweites bevorzugtes Ausführungsbeispiel des Halbleiterlaser-Aufbaus 1. Im Unterschied zu dem in Figur 1 dargestellten ersten Ausführungsbeispiel ist die Mikrolinse 14 eine GRIN-Linse. Auch hier ist das Fenster 5 des Gehäuses 2 gegenüber der Mittelachse des Laserstrahls 7 geneigt. Die Neigung des Fensters 5 ist derart, dass an dem Fenster 5 auftretende Reflexionen des Laserstrahls 7 in Richtung des Halbleiterlaserchips 6 die Laserapertur 8 verfehlen. Außerdem weist das Fenster 5 an der Innenseite 18 eine Antireflexbeschichtung 19 auf, die auch bei dem Halbleiterlaser-Aufbau 1 gemäß Figur 1 optional möglich ist.

Die GRIN-Linse 14 ist ebenfalls eine Sammellinse. Sie ist zylindrisch ausgebildet und weist eine erste plane Grenzfläche 16 auf, die der Laserapertur 8 zugeordnet ist und sich parallel zu dieser erstreckt. Die GRIN-Linse 14 weist außerdem noch eine zweite plane Grenzfläche als Austrittsfläche 17 auf, die dem Fenster 5 zugeordnet ist. Die Austrittsfläche 17 liegt dem Fenster 5 direkt gegenüber, wobei die Austrittsfläche 17 gegenüber der Mittelachse der GRIN-Linse 14 und dem Fenster 5 geneigt ist. Die Neigung der Austrittsfläche 17 gegenüber dem Fenster 5 ist jedoch prinzipiell beliebig. Die GRIN-Linse 14 ist konzentrisch zu der Laserapertur 8 angeordnet. Die Grenzfläche 16 der als GRIN-Linse ausgeführten Mikrolinse 14 ist mit der Laserapertur 8 mittels einer Klebstoffschicht 15 stoffschlüssig verbunden. Ansonsten unterscheidet sich der Aufbau dieses Halbleiterlaser-Aufbaus 1 nicht von dem Aufbau dem in der Figur 1 gezeigten Halbleiterlaser-Aufbau 1.

## Patentansprüche

1. Halbleiterlaser-Aufbau (1) zur Gasdetektion, mit einem Halbleiterlaserchip (6) und einer geregelten Temperiereinrichtung (9, 12), auf der der Halbleiterlaserchip (6) angeordnet ist, mit einem hermetisch abdichtenden Gehäuse (2) mit elektrischen Anschlüssen (3), das einen Boden (4) und ein Fenster (5) aufweist, wobei in dem Gehäuse (2) der Halbleiterlaserchip (6) und die Temperiereinrichtung (9, 12) für den Halbleiterlaserchip (6) angeordnet sind, zwischen dem Halbleiterlaserchip (6) und dem Fenster (5) des Gehäuses (2) ein optisches für das Laserlicht durchlässiges Strahlformungselement (14) angeordnet ist, das einen aus einer Laserapertur (8) des Halbleiterlaserchips (6) ausgehenden Laserstrahl (7) vor dem Durchtritt durch das Fenster (5) kollimiert, das Fenster (5) des Gehäuses (2) gegenüber der Mittelachse des Laserstrahls (7) derart geneigt angeordnet ist, dass an dem Fenster (5) auftretende Reflexionen des Laserstrahls (7) die Laserapertur (8) verfehlen und wobei das Strahlformungselement (14) adhäsiv und/oder stoffschlüssig an dem Halbleiterlaserchip (6) befestigt und mit der Laserapertur optisch und mechanisch verbunden ist und gegenüber dem Halbleiterlaserchip (6) einen konstanten Temperaturzustand aufweist, und wobei das Strahlformungselement (14) eine als gesondertes Teil aus einem für das Laserlicht durchlässigen Werkstoff hergestellte kugelförmige Mikrolinse mit konstantem Brechungsindex oder eine zylindrische GRIN-Linse mit sich stetig änderndem Brechungsindex ist und wobei das Strahlformungselement (14) eine parallel zu der Laserapertur verlaufende dieser zugewandte Grenzfläche aufweist, die zumindest mit der Laserapertur (8) optisch und mechanisch über eine Schicht (15) aus Klebstoff aus einem für das Laserlicht durchgängigen Material verbunden ist, das vorzugsweise einen dem Strahlformungselement (14) ähnlichen oder gleichen Brechungsindex aufweist, und dass der Azimutwinkel der Neigung des Fensters (5) einen festen Bezug zum Polarisationsvektor des Laserstrahls (7) aufweist und dass sich der auf die dem Strahlformungselement (14) zugewandte Innenseite des Fensters (5) treffende Laserstrahl bezüglich Transmission und Reflektion gemäss dem Brewster-Gesetz verhält.

2. Halbleiterlaser-Aufbau nach Anspruch 1, **dadurch gekennzeichnet, dass** die optische Achse des Strahlformungselements (14) gegenüber der Mittelachse der Laserapertur (8) versetzt angeordnet ist.

3. Halbleiterlaser-Aufbau nach Anspruch 1 oder 2, **dadurch gekennzeichnet, dass** die der Laserapertur (8) abgewandte Grenzfläche (17) des als GRIN-Linse ausgebildeten Strahlformungselementes (14) abgeschrägt ausgeführt ist.

4. Halbleiterlaser-Aufbau nach einem der vorangegangenen Ansprüche, **dadurch gekennzeichnet, dass** die Laserapertur (8) in der Fokalebene des Strahlformungselements (14) angeordnet ist.

5. Halbleiterlaser-Aufbau nach Anspruch 1, **dadurch gekennzeichnet, dass** die Temperiereinrichtung (12) einen Temperatursensor (9) auf einer dem Fenster (5) zugewandten oberen Flachseite (11) aufweist, und mit einer unteren Flachseite (13) mit dem Boden (4) des Gehäuses (2) verbunden ist.

6. Halbleiterlaser-Aufbau nach Anspruch 1, **dadurch gekennzeichnet, dass** das Fenster (5) des Gehäuses (2) eine Antireflexbeschichtung aufweist.

## Claims

1. Semiconductor laser structure (1) for use in gas detection, with a semiconductor laser chip (6) and a temperature control system (9, 12), on which the semiconductor laser chip (6) is arranged, with a hermetically sealed housing (2) with electrical connections (3), having a bottom (4) and a window (5), wherein the semiconductor laser chip (6) and the temperature control system (9, 12) are arranged in the housing (2), between the semiconductor laser chip (6) and the temperature control system (9, 12) an optical for the laser light transparent beam shaping element (14) is arranged, that collimates a laser beam (7) emerging from a laser aperture (8) of the semiconductor laser chip (6) prior to its passage through the window (5), the window (5) of the housing (2) is inclined relative to the center axis of the laser beam (7) in such a way that reflections of the laser beam (7) occurring at the window (5) miss the laser aperture (8) and wherein the beam shaping element (14) is fastened at the semiconductor laser chip (6) adhesive and/or firmly bonded and is connected to the laser aperture optically and mechanically and has a constant temperature condition relative to the semiconductor laser chip (6), and wherein the beam shaping element (14) is a spherical microlens with constant refractory index being manufactured as a separate part from material that is transmissive for the laser light or is a cylindrical GRIN lens with a steadily changing refractory index, and wherein the beam shaping element (14) comprises a boundary surface facing the laser aperture that extends parallel to the laser aperture and is connected at least to the laser aperture optically and mechanically via a layer (15) of a glue from a material being transmissive for the laser light, which preferably has a refractory index being similar or equal to the refractory index of the beam shaping element (14), and that the azimuth angle of the window inclination has a fixed relationship to the polarization vector of the laser beam (7) and that the laser beam (7) hitting the inside surface of the window (5) acts in accordance with Brewster's law in terms of transmission and reflection.

2. Semiconductor laser structure according to claim 1, **characterized in, that** the optical axis of the beam shaping element (14) is offset in relation to the center axis of the laser aperture (8).

3. Semiconductor laser structure according to claim 1 or 2, **characterized in, that** the boundary surface (17) facing away from the laser aperture (8) of the beam shaping element (14) being implemented as a GRIN lens is sloped.

4. Semiconductor laser structure according to any one of the preceding claims, **characterized in, that** the laser aperture (8) is located in the focal plane of the beam shaping element (14).

5. Semiconductor laser structure according to claim 1, **characterized in, that** the temperature control system (12) has a thermal sensor (9) on an upper flat surface (11) facing the window (5), and is connected via a lower flat surface (13) to the bottom (4) of the housing (2).

6. Semiconductor laser structure according to claim 1, **characterized in, that** the window (5) of the housing (2) has an anti-reflection coating (19).

## Revendications

1. Système laser à semiconducteur (1) pour la détection de gaz, avec une puce de laser à semiconducteur (6) et un dispositif d'équilibrage de température régulé (9, 12), sur lequel la puce de laser à semiconducteur (6) est disposée, avec un boîtier (2) fermant hermétiquement qui est muni de connexions électriques (3) et qui présente un fond (4) et une fenêtre (5), la puce de laser à semiconducteur (6) et le dispositif d'équilibrage de température (9, 12) pour la puce de laser à semiconducteur (6) étant disposés dans le boîtier (2), un élément de mise en forme de faisceau (14) optique, transparent à la lumière laser, étant disposé entre la puce de laser à semiconducteur (6) et la fenêtre (5) du boîtier (2), lequel collimate un faisceau laser (7) provenant d'une ouverture laser (8) de la puce de laser à semiconducteur (6) avant son passage à travers la fenêtre (5), la fenêtre (5) du boîtier (2) étant inclinée par rapport à l'axe médian du faisceau laser (7) de façon que les réflexions du faisceau laser (7) se produisant sur la fenêtre (5) manquent l'ouverture laser (8) et l'élément de mise en forme de faisceau (14) étant fixé à la puce de laser à semiconducteur (6) par adhérence et/ou par liaison de matière, relié à l'ouverture laser optiquement et mécaniquement et présentant un état de température constant par rapport à la puce de laser à semiconducteur (6), et l'élément de mise en forme de faisceau (14) étant une microlentille sphérique fabriquée sous forme de pièce séparée dans un matériau transparent à la lumière laser, ayant un indice de réfraction constant, ou une lentille GRIN cylindrique ayant un indice de réfraction continûment variable et l'élément de mise en forme de faisceau (14) présentant une surface limite s'étendant parallèlement à l'ouverture laser et tournée vers elle, qui est reliée au moins à l'ouverture laser (8) optiquement et mécaniquement par une couche (15) de colle dans un matériau transparent à la lumière laser, qui présente de préférence un indice de réfraction comparable ou égal à celui de l'élément de mise en forme de faisceau (14), et l'angle azimutal de l'inclinaison de la fenêtre (5) ayant un rapport fixe avec le vecteur de polarisation du faisceau laser (7) et le faisceau laser qui atteint le côté intérieur de la fenêtre (5) tourné vers l'élément de mise en forme de faisceau (14) se comportant selon la loi de Brewster en ce qui concerne la transmission et la réflexion.

2. Système laser à semiconducteur selon la revendication 1, **caractérisé en ce que** l'axe optique de l'élément de mise en forme de faisceau (14) est décalé par rapport à l'axe médian de l'ouverture laser (8).

3. Système laser à semiconducteur selon la revendication 1 ou 2, **caractérisé en ce que** la surface limite (17) de l'élément de mise en forme de faisceau (14) réalisé sous la forme d'une lentille GRIN qui est éloignée de l'ouverture laser (8) est biseautée.

4. Système laser à semiconducteur selon une des revendications précédentes, **caractérisé en ce que** l'ouverture laser (8) est disposée dans le plan focal de l'élément de mise en forme de faisceau (14).

5. Système laser à semiconducteur selon la revendication 1, **caractérisé en ce que** le dispositif d'équilibrage de température (12) présente un capteur de température (9) sur un côté plat supérieur (11) tourné vers la fenêtre (5) et est relié au fond (4) du boîtier (2) par un côté plat inférieur (13).

6. Système laser à semiconducteur selon la revendication 1, **caractérisé en ce que** la fenêtre (5) du boîtier (2) présente un revêtement antireflet.
